(19) Europäisches Patentamt
European Patent Office
Office européen des brevets

(11) EP 4 568 038 A1

(12) EUROPÄISCHE PATENTANMELDUNG

(43) Veröffentlichungstag:
11.06.2025 Patentblatt 2025/24

(21) Anmeldenummer: 24214676.9

(22) Anmeldetag: 22.11.2024

(51) Internationale Patentklassifikation (IPC):
H02H 3/33 (2006.01)    H02H 5/10 (2006.01)

(52) Gemeinsame Patentklassifikation (CPC):
H02H 3/33; H02H 5/10; G01R 31/52; H02H 1/0061

(84) Benannte Vertragsstaaten:
AL AT BE BG CH CY CZ DE DK EE ES FI FR GB
GR HR HU IE IS IT LI LT LU LV MC ME MK MT NL
NO PL PT RO RS SE SI SK SM TR
Benannte Erstreckungsstaaten:
BA
Benannte Validierungsstaaten:
GE KH MA MD TN

(30) Priorität: 27.11.2023 DE 102023133033

(71) Anmelder: Doepke Schaltgeräte GmbH, Norden
26506 Norden (DE)

(72) Erfinder:
• Roolfs, Gerold
26529 Upgant-Schott (DE)
• Grünebast, Günter
26506 Norden (DE)

(54) **VORRICHTUNG UND VERFAHREN ZUR DIFFERENZSTROMÜBERWACHUNG**

(57) Eine Vorrichtung sowie ein Verfahren zur Differenzstromüberwachung in elektrischen Anlagen mit wenigstens zwei Stromleitungen, aufweisend einen, zumindest eine Sekundärwicklung umfassenden Summenstromwandler durch den die wenigstens zwei Stromleitungen geführt sind welche die Primärwicklungen des Summenstromwandlers ausbilden, eine mit der Sekundärwicklung verbundene Auswerteeinheit, die dazu ausgebildet ist, das Summenstromsignal der Sekundärwicklung frequenzselektiv zu filtern und für zumindest zwei Frequenzbereiche den jeweiligen Effektivwert des Summenstromsignals in jedem dieser Frequenzbereiche zu ermitteln, wobei die Auswerteeinheit weiter dazu ausgebildet ist den für jeden Frequenzbereich ermittelten Effektivwert mit zumindest zwei frequenzbereichsabhängigen Schwellwerten zu vergleichen und bei einer Überschreitung eines ersten Schwellwertes ein frequenzbereichsabhängiges erstes Alarmsignal auszugeben und bei einer Unterschreitung eines zweiten Schwellwertes ein frequenzbereichsabhängiges zweites Alarmsignal auszugeben.

Fig. 1

EP 4 568 038 A1

**Beschreibung**

Die Erfindung betrifft eine Vorrichtung zur Differenzstromüberwachung in elektrischen Anlagen mit wenigstens zwei Stromleitungen, aufweisend wenigstens einen zumindest eine Sekundärwicklung umfassenden Summenstromwandler, durch den die wenigstens zwei Stromleitungen geführt sind und diese die Primärwicklungen des Summenstromwandlers ausbilden, weiter aufweisend eine mit der Sekundärwicklung verbundene Auswerteeinheit. Die Erfindung betrifft des Weiteren ein Verfahren zur Differenzstromüberwachung mittels einer vorgenannten Vorrichtung.

Vorrichtungen und Verfahren zur Überwachung von Differenzströmen insbesondere in elektrischen Niederspannungsstromkreisen von elektrischen Anlagen sind im Stand der Technik zum Beispiel als Differenzstrom-Überwachungsgeräte (RCM) oder als Differenzstrom-Analysesysteme bekannt. Diese Geräte und Systeme erfassen die vektorielle Summe der in die elektrische Anlage hineinfließenden Ströme als Differenzstrom und bewirken, falls dieser einen Grenzwert überschreitet, eine Meldung in digitaler oder analoger Art beispielsweise optisch oder akustisch bewirken oder eine Abschaltung des zu überwachenden Stromkreises der elektrischen Anlage bewirken. Der Begriff Niederspannung umfasst Wechselspannungen bis 1000 V und/oder Gleichspannungen bis 1500 V. Die Erfassung eines Differenzstromes mit Hilfe eines Summenstromwandlers setzt das Fließen von elektrischem Strom in zumindest zwei Stromleitungen voraus, die durch den Summenstromwandler geführt sind. Bei einem einphasigen Stromkreis sind das ein Außenleiter und der Neutralleiter. Bei einem Drehstromkreis sind das drei Außenleiter und der Neutralleiter.

Vorrichtungen und Verfahren zur Überwachung von Differenzströmen werden vorzugsweise in geerdeten Stromnetzen eingesetzt.

Der Begriff Differenzstrom umfasst Fehlerströme und Ableitströme. Die mit Hilfe des Summenstromwandlers als Differenzströme erfassten Summenströme entstehen aus der Summe der zeitlichen Verläufe von Fehlerströmen und Ableitströmen. Fehlerströme sind ohmsch, während Ableitströme kapazitiv oder induktiv sind. Fehlerströme treten aufgrund von Isolationsfehlern eines elektrischen Betriebsmittels oder bei Berührung eines aktiven elektrischen Leiters durch eine geerdete Person auf. Zum Schutz vor unzulässig hohen und gefährlichen Fehlerströmen ist die Verwendung von Fehlerstrom-Schutzeinrichtungen (RCDs) bekannt, wobei diese grundsätzlich eine Trennung des zu schützenden Stromkreises bewirken, wenn der Fehlerstrom einen bestimmten Grenzwert überschreitet. Ableitströme sind betriebsbedingte Ströme, die nicht aufgrund von Fehlern, wie zum Beispiel Isolationsfehler, in einer elektrischen Anlage generiert werden. Sie treten kurzzeitig, dynamisch aber auch stationär üblicherweise auf, und fließen üblicherweise über Entstör-Kondensatoren oder parasitäre Kapazitäten von Betriebsmitteln gegen Erde ab. Sie können auch durch magnetische Kopplungen aufgrund parallel liegender bestromter elektrischer Leitungen entstehen. Ableitströme sind somit kapazitiv oder induktiv. Derartige Ableitströme können bei elektronischen Betriebsmitteln, wie zum Beispiel Frequenzumrichter mit Motor und EMV-Filter aufgrund von EMV-Maßnahmen mit breitem Frequenzspektrum auftreten. Üblich sind hier Ableitströme im Bereich der Maschinenfrequenz von einigen Hertz bis ca. 100 Hz sowie Ableitströme der Netzfrequenz und deren Harmonische, wie zum Beispiel 50 Hz, 150 Hz, 450 Hz, etc., aber auch Ableitströme bedingt durch die Schaltfrequenz des Frequenzumrichters welche mehrere kHz nebst Harmonischen betragen können, typischerweise bis etwa 100 kHz. Je nach Betrieb eines Frequenzumrichters, wie zum Beispiel Stillstand, Anfahren, Dauerbetrieb oder Abbremsen, sowie dessen Art und Ausgestaltung der EMV-Filtermaßnahmen kann sich das Frequenzspektrum des Ableitstromes erheblich ändern. Mit Hilfe des Frequenzspektrums des Ableitstromes lässt sich auch der Zustand einer elektrischen Anlage oder deren Betriebsmittel bestimmen.

Fehlerstrom-Schutzeinrichtungen (RCDs) müssen bei Erfassung eines unzulässig hohen Fehlerstromes innerhalb von normativ vorgegebenen Zeiten schnell, üblicherweise < 300 ms, abschalten, um Personen und elektrische Anlagen vor Gefahren zu schützen. Differenzstrom-Überwachungsgeräte (RCMs) hingegen können den Differenzstrom über einen längeren Zeitraum, zum Beispiel mehrere Sekunden, überwachen, bevor sie eine Meldung bewirken, wenn ein Differenzstromgrenzwert überschritten wird. Daher eignen sich Vorrichtungen zur Differenzstromüberwachung u.a. zur Erhöhung der Anlagen- und Betriebssicherheit und Überwachung der Stromversorgung. Somit können sie auch gemeinsam mit Fehlerstrom-Schutzeinrichtungen (RCDs) verwendet werden. Durch eine permanente Überwachung der Differenzströme können Fehler in der elektrischen Anlage schon vor Ansprechen der Schutzeinrichtung erkannt und gemeldet werden. Eine plötzliche Abschaltung der elektrischen Anlage kann somit oft vermieden werden. Vorrichtungen zur Differenzstromüberwachung werden daher auch in elektrischen Anlagen eingesetzt, in denen im Fehlerfall eine Meldung, jedoch keine Abschaltung erfolgen soll. Zudem können Vorrichtungen zur Differenzstromüberwachung in elektrischen Anlagen als Maßnahme zur vorbeugenden Instandhaltung vorgesehen werden. Aus dem Stand der Technik ist ein Differenzstrom-Analysesystem zur Differenzstromüberwachung des Herstellers Doepke Schaltgeräte GmbH mit der Bezeichnung DRCA-1 bekannt. Das Differenzstrom-Analysesystem bietet die Möglichkeit mit Hilfe eines Summenstromwandlers, eines Auswertegerätes und einer Software, die auf jedem handelsüblichen Computer aufgespielt werden kann, die Möglichkeit, den Differenzstrom zu analysieren. Beispielsweise lässt sich der Differenzstrom frequenzselektiv durch Filterung in mehrere Frequenzbereiche aufteilen und separat analysieren.

Des Weiteren ist aus DE 102 37 342 ein Verfahren und eine Vorrichtung zur Fehlerstromüberwachung aus dem Stand der Technik bekannt. Es wird ein Fehlerstrom in einem elektrischen Wechselstromnetz mit einer Mehrzahl von Stromleitungen überwacht, wobei der als Summenstrom erfasste Fehlerstrom in Blöcken mit verschiedenen spektralen Anteilen aufgeteilt wird und hinsichtlich des Überschreitens von Grenzwerten eine Gefährlichkeit des Fehlerstromes ermittelt wird.

Aus DE 10 2018 208 077 ist aus dem Stand der Technik eine Differenzstromeinheit zur Überwachung eines Niederspannungsstromkreises mit Hilfe eines Summenstromwandlers bekannt, wobei das Summenstromsignal des Summenstromwandlers derart gefiltert wird, dass für bestimmte Frequenzbereiche Amplitudenwerte des Summenstromsignals ermittelt werden und dass pro Frequenzbereich der ermittelte Amplitudenwert mit einem frequenzbereichsabhängigen Schwellwert verglichen wird und bei Überschreiten eines Schwellwertes ein Warnsignal abgegeben wird. Nachteilig ist, dass bei den zuvor genannten Vorrichtungen und Verfahren aus dem Stand der Technik eine Meldung bewirkt wird, wenn nur ein Schwellwert und nicht mehrere Schwellwerte unterschiedlicher Höhe überschritten werden. Zudem ist es: besonders nachteilig, dass keine Meldung bewirkt wird, wenn ein Schwellwert unterschritten wird.

Beispielsweise fließt in einer elektrischen Anlage mit einem Frequenzumrichter und Motor sowie EMV-Filter auch im Stillstand des Motors ein Differenzstrom als statischer Ableitstrom mit bestimmten Werten in bestimmten Frequenzbereichen bedingt durch die gegen Erde (Schutzleiter) geschalteten Kondensatoren des EMV-Filters. Eine Unterschreitung dieser bestimmten Werte kann darauf hinweisen, dass der Schutzleiterstromkreis unzulässig unterbrochen ist und somit kein Ableitstrom mehr gegen Erde fließt. Damit ist das EMV-Filter nicht mehr mit Erde verbunden und die zulässigen Grenzwerte zur Einhaltung einschlägiger EMV-Vorschriften werden in negativer Weise nicht mehr eingehalten. Zudem kann dieser unterbrochene Schutzleiterstromkreis bei Berührung durch eine Person in negativer Weise einen gefährlichen Körperstrom bewirken.

Des Weiteren ist es nachteilig, wenn Schwellwerte von Frequenzbereichen mit Amplitudenwerten des Summenstromsignals verglichen werden und bei Überschreitung eine Meldung als Alarmsignal bewirken. Amplitudenwerte, auch als Scheitelwerte oder Spitzenwerte bezeichnet, beschreiben einen Momentan- oder Augenblickswert. Ein Effektivwert hingegen ist ein Wert, welcher über eine bestimmte Zeit ermittelt wird. Er wird auch als quadratischer zeitlicher Mittelwert bezeichnet. Amplitudenwerte sind hingegen nicht zeitbezogen. Ein Amplitudenwert kann der Scheitelwert einer periodischen Schwingung (Sinus) sein. Der Effektivwert einer periodischen Schwingung ergibt sich per Integration einer Funktion über eine bestimmte Zeit. Der Effektivwert des Summenstromsignals ergibt sich dabei entweder als quadratischer Mittelwert über die Periodendauer, oder als 1,1 x Betragsmittelwert.

Dabei ist der Betragsmittelwert $|\bar{I}|$ des Stroms I wie folgt definiert:

$$|\bar{I}| = \frac{1}{T} \int_0^T |I| dt$$

Wobei $|I|$ der Absolutwert des Stromes ist, welcher über den Zeitraum T integriert wird, wobei T sehr viel größer als eine Periode ist. Schaltungstechnisch lässt sich dies beispielsweise durch einen analogen Gleichrichter gefolgt von einem Verstärker realisieren. Alternativ lässt sich bei einer digitalen Lösung der Effektivwert direkt durch Bildung des quadratischen Mittelwertes berechnen. Bei einer sinusförmigen Schwingung ist das Verhältnis von Amplitudenwert zu Effektivwert 1,41. Bei Schalthandlungen im Stromnetz, bei Gewitter oder auch beim regulären Betrieb von elektronischen Betriebsmitteln in elektrischen Anlagen können Differenzströme jedoch sehr hohe Amplitudenwerte aufweisen, während der Effektivwert des Differenzstromes erheblich niedriger ist. Die Berücksichtigung von Amplitudenwerten führt in negativer Weise zu einer fehlerhaften Bewertung des Differenzstromes und somit zu unerwünschten Alarmsignalen. Beispielsweise kann bei Berücksichtigung von Amplitudenwerten ein durch ein Gewitter generierter kurzzeitiger Differenzstrom mit hohem Amplitudenwert (auch als Stoßstrom bezeichnet) in negativer Weise eine Meldung oder eine Abschaltung bewirken, während der statische Effektivwert des Differenzstromes unverändert ist.

Der Erfindung liegt die Aufgabe zugrunde, eine Vorrichtung und ein Verfahren zur Differenzstromüberwachung der eingangs genannten Gattung zu verbessern, insbesondere um eine umfassendere Bewertung der Differenzströme bei Reduzierung unerwünschter Meldungen bzw. Alarmsignale zu erreichen.

Diese Aufgabe ist für die Vorrichtung erfindungsgemäß dadurch gelöst, dass die Auswerteeinheit dazu ausgebildet ist, das Summenstromsignal der Sekundärwicklung frequenzselektiv zu filtern und für zumindest zwei Frequenzbereiche den jeweiligen Effektivwert dieser Frequenzbereiche zu ermitteln, und dass die Auswerteeinheit weiter dazu ausgebildet ist, den für jeden Frequenzbereich ermittelten Effektivwert mit zumindest zwei frequenzbereichsabhängigen Schwellwerten zu vergleichen und bei einer Überschreitung eines ersten Schwellwertes ein frequenzbereichsabhängiges erstes Alarmsignal auszugeben und bei einer Unterschreitung eines zweiten Schwellwertes ein frequenzbereichsabhängiges zweites Alarmsignal auszugeben.

Im Gegensatz zu einem Amplitudenwert wird ein Effektivwert in einfacher Weise, wie weiter oben beschrieben, über einen definierten Zeitraum bestimmt, so dass kurzzeitige Differenzströme mit hohen Amplitudenwerten keine negativen Auswirkungen auf die Bewertung des Differenzstromes haben. In vorteilhafter Weise kommt es bei einem Vergleich eines erfindungsgemäß ermittelten Effektivwertes mit definierten Schwellwerten nicht zu fehlerhaften Bewertungen des Differenzstromes und somit zu unerwünschten Alarmsignalen.

Des Weiteren ist es vorteilhaft, wenn ermittelte Effektivwerte des Differenzstromes nicht nur mit einem oberen Schwellwert, sondern erfindungsgemäß auch mit einem unteren Schwellwert verglichen werden. Eine Unterschreitung eines Schwellwertes kann darauf hinweisen, dass beispielsweise der Schutzleiterstromkreis eines EMV-Filters unzulässig unterbrochen ist und somit kein Ableitstrom mehr gegen Erde fließt. Dadurch ist das EMV-Filter nicht mehr mit Erde verbunden und die zulässigen Grenzwerte zur Einhaltung einschlägiger EMV-Vorschriften werden nicht mehr eingehalten. Zudem kann dieser unterbrochene Schutzleiterstromkreis bei Berührung durch eine Person einen gefährlichen Körperstrom bewirken. Bei dem erfindungsgemäßen Vergleich des Effektivwertes eines Differenzstromes mit einem unteren Schwellwert, kann in vorteilhafter Weise ein Alarmsignal oder auch ein Abschaltsignal bereitgestellt werden, welches in Verbindung mit einer Abschalteinrichtung zur Abschaltung der zu überwachenden elektrischen Anlage führen kann. Besonders vorteilhaft ist es, wenn, wie erfindungsgemäß vorgesehen, der für jeden Frequenzbereich ermittelte Effektivwert mit zwei frequenzbereichsabhängigen Schwellwerten verglichen wird. Dadurch kann eine genauere Überwachung der auftretenden Differenzströme, insbesondere nach diskreten Frequenzen bzw. Frequenzbereichen gestaffelt, erfolgen.

Treten beispielsweise beim Betrieb eines Frequenzumrichters mit Motor und EMV-Filter ungewöhnlich hohe Frequenzanteile im Bereich von einigen kHz im Differenzstrom auf, kann es ein Hinweis darauf sein, dass sich das EMV-Filter in einem unzulässigen Resonanz-Zustand befindet und die vorgesehene Aufgabe als EMV-Filter nicht mehr erfüllt. Wird der Effektivwert des Differenzstromes in dem zuvor genannten Frequenzbereich mit einem ersten Schwellwert verglichen und eine Überschreitung dieses ersten Schwellwertes festgestellt, kann ein erstes Alarmsignal ausgegeben werden. Dieses ist vorteilhaft, weil der Benutzer aufgrund dieses frequenzbereichsabhängigen ersten Alarmsignals den Missstand in einfacher Weise beheben kann, in dem die Schaltfrequenz des Frequenzumrichters verändert und somit eine unerwünschte Resonanz des EMV-Filters verhindert wird.

Spektralanteile eines Differenzstromes, welche beispielsweise von EMV-Filtern in elektrischen Drehstromsystemen unter üblichen Betriebsbedingungen generiert werden, auch wenn das dem EMV-Filter zugeordnete elektrische Betriebsmittel (zum Beispiel ein Frequenzumrichter) nicht aktiv ist, sind im Stand der Technik bekannt. Insbesondere handelt es sich hierbei um die diskreten Frequenzen 50, 150, 450, 750, 1050 Hz. Die Mindestwerte der als Ableitstrom auftretenden Spektralanteile können berechnet werden, wenn die Netzspannung und die im EMV-Filter integrierten elektronischen Bauelemente (zum Beispiel Kondensatoren und Spulen) bekannt sind. Auch durch eine Messung im bestimmungsgemäßen und ungestörten Betrieb können diese Werte ermittelt werden. Somit kann bei jeder der zuvor genannten diskreten Frequenz oder auch bei einem Frequenzbereich (zum Beispiel von 100 Hz bis 1000 Hz) ein zweiter Schwellwert definiert werden. Wird nun ein frequenzbereichsabhängiger Effektivwert des Differenzstromes zum Beispiel im Frequenzbereich von 100 Hz bis 1000 Hz erfindungsgemäß mit einem definierten zweiten Schwellwert verglichen und ein Unterschreiten dieses zweiten Schwellwertes ermittelt, so kann darauf geschlossen werden, dass die elektrischen Verbindungen zum EMV-Filter nicht, wie bestimmungsgemäß vorgesehen, vorhanden sind und somit ein frequenzbereichsabhängiges zweites Alarmsignal generiert wird.

Eine weitere Verbesserung wird erreicht, wenn zum Ermitteln möglicher Fehlerquellen in elektrischen Anlagen die Vorrichtung zur Differenzstromüberwachung erfindungsgemäß mittels Methoden des maschinellen Lernens (Machine Learning) als Kernfunktion der künstlichen Intelligenz (KI) Anomalien im Differenzstrom erkennt. Maschinelles Lernen wird durch Algorithmen in einer Software umgesetzt. Mittels einer Software wird der erfasste Differenzstrom über einen bestimmten Zeitraum analysiert. Es wird in diesem Zeitraum vorzugsweise zugrunde gelegt, dass die elektrische Anlage bestimmungsgemäß funktioniert, wobei der Differenzstrom in der elektrischen Anlage als reiner kapazitiver und/oder induktiver Ableitstrom und nicht als ohmscher Fehlerstrom fließt. Dieses setzt voraus, dass die elektrische Anlage frei von Isolationsfehlern ist und dass kein Fehlerstrom als unzulässiger Körperstrom durch eine Person fließt. Unter bestimmten Voraussetzungen kann es jedoch vorteilhaft sein, einen geringen Anteil von maximal 20 % im Differenzstrom zu berücksichtigen, welcher durch Fehler bedingt als Fehlerstrom fließt.

Wie bereits weiter oben aufgeführt, fließen betriebsbedingte Ableitströme als Differenzströme beispielsweise aufgrund von EMV-Maßnahmen im bestimmungsgemäßen Betrieb einer elektrischen Anlage mit elektronischen Betriebsmitteln, wie zum Beispiel Frequenzumrichter. Diese Differenzströme weisen hierbei ein bestimmtes charakteristisches Spektrum auf, welches sich frequenzbereichsabhängig analysieren lässt.

Nach der über einen bestimmten Zeitraum erfolgten Auswertung und Analyse des Differenzstromes kann die Vorrichtung zur Differenzstromüberwachung mittels dieses bekannten bestimmten charakteristischen Spektrums des Differenzstroms Anomalien aufgrund von Unterschieden zum aktuell vorhandenen Differenzstrom erkennen oder auch aufgrund von Unterschieden zu einem über einen weiteren Zeitraum erfassten Differenzstromes erkennen. Diese Anomalien können beispielsweise durch Isolationsfehler in der elektrischen Anlage oder durch unzulässige Betriebszustände von Betriebsmitteln sowie auch durch unterbrochene Schutzleiterverbindungen bedingt sein. Diese Anomalien können von der Art sein, dass ein Betrieb der elektrischen Anlage zunächst weiter möglich ist, wobei dem Nutzer der elektrischen Anlage durch das Melden oder Anzeigen von Anomalien eine Information zum Beispiel als Voralarm oder mittels einer als Computer mit Software ausgeführten Zentraleinheit bereitgestellt wird, um auch mögliche Fehlerquellen, also Entstehungsorte von unzulässigen Differenzströmen, zu bestimmen und abzustellen. In vorteilhafter Weise kann durch das Bestimmen oben genannter Anomalien eine weitere Steigerung der Verfügbarkeit einer elektrischen Anlage erreicht werden. Bevorzugt ist vorgesehen, dass sich die Software zum maschinellen Lernen in einer Cloud befindet. Alternativ kann sich diese Software auch in einem zur Herstellung von Datenverbindungen vorgesehenen Gateway oder an einem anderen Ort mit einer Möglichkeit zur Speicherung von Software befinden.

Weiterhin ist eine Verbesserung vorgesehen, wobei zur weiteren Steigerung sowohl der Verfügbarkeit als auch des sicheren Betriebes einer elektrischen Anlage, die Vorrichtung zur Differenzstromüberwachung erfindungsgemäß mittels Methoden des maschinellen Lernens durch Erlerntes aus der Vergangenheit zukünftige Vorhersagen bezüglich möglicher kritischer Änderungen des Differenzstromes sowohl zum Ort der Entstehung als auch zum Zeitpunkt des Entstehens treffen kann. Maschinelles Lernen sieht hier vor, dass Software sich selbst Regeln durch Beispiele und durch das Erlernte aus der Vergangenheit aneignet, um zukünftig Vorhersagen treffen zu können, wie sich zum Beispiel Effektivwerte von Frequenzbereichen oder von einzelnen Frequenzen des Differenzstromes aber auch des gesamten Differenzstromes ändern werden. Dadurch können dem Nutzer der elektrischen Anlage, auch unter dem Aspekt der vorbeugenden Instandhaltung, in vorteilhafter Weise frühzeitig zukünftige unzulässige Änderungen des Differenzstromes mitgeteilt werden, um unzulässige Zustände oder Ausfälle in der elektrischen Anlage zu vermeiden. Eine solche Mitteilung kann mittels einer einfachen optischen oder akustischen Meldung erfolgen oder mittels einer als Computer mit Software ausgeführten Zentraleinheit, wobei eine solche Zentraleinheit eine frequenzselektive Darstellung des Differenzstromes ermöglicht. Bevorzugt ist vorgesehen, dass sich die Software zum maschinellen Lernen in einer Cloud befindet. Alternativ kann sich diese Software auch in einem zur Herstellung von Datenverbindungen vorgesehenen Gateway oder an einem anderen Ort mit einer Möglichkeit zur Speicherung von Software befinden.

Hinsichtlich des Verfahrens ist die Aufgabe erfindungsgemäß dadurch gelöst, dass mittels einer vorgenannten Vorrichtung zur Differenzstromüberwachung, bei dem ein Summenstromsignal frequenzselektiv gefiltert wird und für zumindest zwei Frequenzbereiche der jeweilige Effektivwert dieser Frequenzbereiche ermittelt wird, und bei dem für jeden Frequenzbereich der ermittelte Effektivwert mit zumindest zwei frequenzbereichsabhängigen Schwellwerten verglichen wird und dass bei einer Überschreitung eines ersten Schwellwertes ein frequenzbereichsabhängiges erstes Alarmsignal ausgegeben wird und dass bei einer Unterschreitung eines zweiten Schwellwertes ein frequenzbereichsabhängiges zweites Alarmsignal ausgegeben wird.

Dadurch, dass in erfinderischer Weise für jeden Frequenzbereich der ermittelte Effektivwert des Differenzstromes mit zwei frequenzbereichsabhängigen Schwellwerten verglichen wird und dass bei einer Überschreitung eines ersten Schwellwertes ein frequenzbereichsabhängiges erstes Alarmsignal ausgegeben wird und bei einer Unterschreitung eines zweiten Schwellwertes ein frequenzbereichsabhängiges zweites Alarmsignal ausgegeben wird, kann eine deutliche Steigerung sowohl der Verfügbarkeit als auch des sicheren Betriebes einer elektrischen Anlage erreicht werden, wobei es zudem ermöglicht wird, Rückschlüsse auf mögliche Fehlerquellen zu ziehen, wodurch eine verbesserte Fehlerbehebung in einer elektrischen Anlage erreicht wird. Dabei können die jeweils ersten Alarmsignale der unterschiedlichen Frequenzbereiche sowohl gleich als auch jeweils unterschiedlich sein. Die jeweils zweiten Alarmsignale der unterschiedlichen Frequenzbereiche können ebenfalls sowohl gleich als auch jeweils unterschiedlich sein. Ausführungsbeispiele der Erfindung sind in den Abbildungen dargestellt.

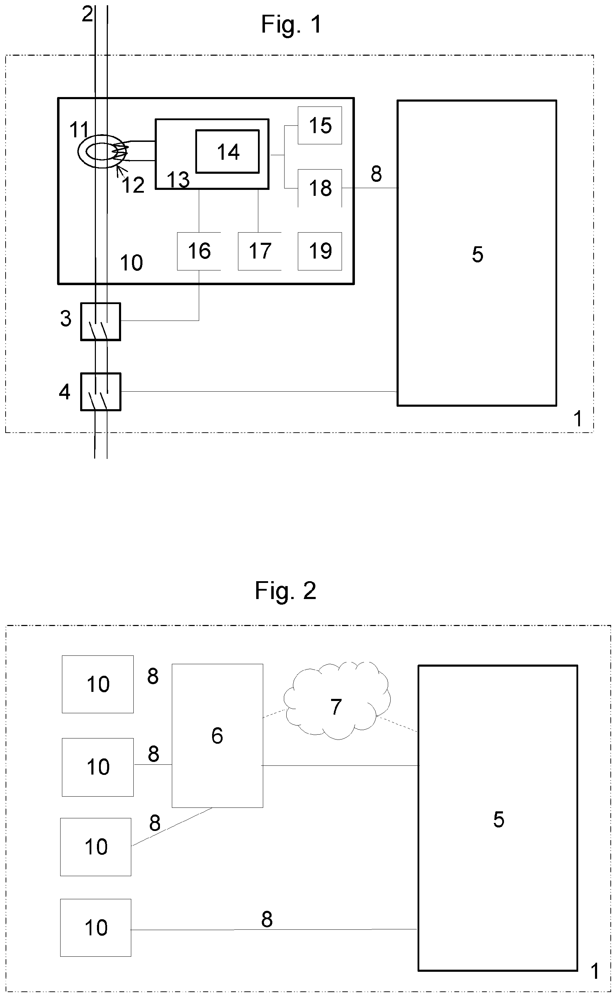

Figur 1 und 2: Vorrichtung zur Ausführung des erfindungsgemäßen Verfahrens zur Differenzstromüberwachung.

Die Vorrichtungen zur Differenzstromüberwachung 1 weisen zur Erfassung von Differenzströmen zumindest einen Summenstromwandler 11 auf. Durch den Summenstromwandler 11 werden die zur Differenzstromüberwachung vorgesehenen zumindest zwei Stromleitungen 2 einer elektrischen Anlage geführt. In einfacher Weise bilden diese Stromleitungen 2 die Primärwicklungen des Summenstromwandlers 11 aus. Der Summenstromwandler 11 umfasst zumindest eine Sekundärwicklung 12, welche mit einer Auswerteeinheit 13 verbunden ist. Je nach weiterer elektrischer Beschaltung in der Auswerteeinheit 13 kann das an den beiden Enden der Sekundärwicklung 12 liegende Summenstromsignal ein genaues Abbild des erfassten Differenzstromes sein und wird in der Auswerteeinheit 13 beispielsweise durch den Vergleich mit Schwellwerten verarbeitet.

Die Auswerteeinheit 13 weist einen Microcomputer mit Softwarespeicher 14 auf. In vorteilhafter Weise können eine einfache Betriebssoftware und wichtige Parameter wie zum Beispiel frequenzbereichsabhängige Schwellwerte oder die Eckfrequenzen von Frequenzbereichen sowie auch der Bemessungsdifferenzstrom als Daten gespeichert werden. Neben der Erfassung von Wechseldifferenzströmen ist die separate Erfassung und Auswertung reiner Gleichdifferenzströme vorgesehen. Dieses ist vorteilhaft, weil somit die Erfassung und Auswertung auch von sehr kleinen Gleichdifferenzströmen möglich ist, wenn gleichzeitig sehr hohe Wechseldifferenzströme unterschiedlichster Frequenzen vorhanden sind.

Für zumindest einen Frequenzbereich wird der ermittelte Effektivwert mit einem dritten frequenzbereichsabhängigen Schwellwert verglichen und wird bei Überschreitung eines dritten Schwellwertes ein frequenzbereichsabhängiges drittes Alarmsignal ausgegeben, wobei der Wert eines dritten frequenzbereichsabhängigen Schwellwertes niedriger ist als der Wert eines ersten frequenzbereichsabhängigen Schwellwertes. Dieses ist vorteilhaft, weil bei einer Überschreitung eines dritten frequenzbereichsabhängigen Schwellwertes ein Alarmsignal als Voralarm ausgegeben wird, wodurch der Nutzer rechtzeitig über eine Veränderung des Differenzstromes informiert wird.

Es ist eine mit der Auswerteeinheit 13 verbundene Anzeigeeinheit 15 vorgesehen, die derart ausgestaltet ist, dass zumindest ein frequenzbereichsabhängiges optisches oder akustisches Alarmsignal oder die Höhe des frequenzbereichsabhängigen Differenzstromes angezeigt wird. Dieses hat den Vorteil, dass eine Anzeige des Alarmsignals bzw. der Höhe des Differenzstromes erfolgt. In einfacher Weise kann die Anzeigeeinheit 15 in optischer Art als einfache LED oder mehrfarbige LED ausgeführt sein. Mit Hilfe der Farben einer mehrfarbigen LED wird der Zustand des Differenzstromes angezeigt. Beispielsweise zeigt die Farbe Grün einen unkritischen Zustand an. Die Farbe Gelb zeigt an, dass ein dritter Schwellwert als Voralarm überschritten wurde. Die Farbe Rot kann vorgesehen sein, um anzuzeigen, dass ein erster Schwellwert als Hauptalarm überschritten wurde. Die Farbe Blau kann vorgesehen sein, um anzuzeigen, dass ein zweiter Schwellwert unterschritten wurde. Weiterhin ist eine mit der Auswerteeinheit 13 verbundene erste Ausgangseinheit 16 vorgesehen, die derart ausgestaltet ist, dass zumindest ein frequenzbereichsabhängiges erstes Alarmsignal eine Schaltung eines Ausganges zum Beispiel mit Hilfe von Kontakten eines Relais oder mit Hilfe eines Halbleiter-Schalters bewirkt. Somit erfolgt in vorteilhafter Weise nicht nur eine optische oder akustische Meldung, sondern es steht auch ein physischer Schaltausgang für Steuerungs- oder Meldezwecke zur Verfügung.

Zudem ist eine mit der Auswerteeinheit 13 verbundene zweite Ausgangseinheit 17 vorgesehen ist, die derart ausgestaltet ist, dass zumindest ein frequenzbereichsabhängiges zweites oder drittes Alarmsignal eine Schaltung eines Ausganges zum Beispiel mit Hilfe von Kontakten eines Relais oder mit Hilfe eines Halbleiter-Schalters bewirkt. Somit erfolgt in vorteilhafter Weise nicht nur eine optische oder akustische Meldung, sondern es steht auch ein physischer Schaltausgang für Steuerungs- oder Meldezwecke zur Verfügung, welcher beispielsweise bei Unterschreitung eines zweiten Schwellwertes verwendet werden kann.

In der gezeigten Ausgestaltung der Erfindung ist eine mit der Auswerteeinheit 13 verbundene Kommunikationsschnittstelle 18 vorgesehen, über die zumindest ein frequenzbereichsabhängiges Alarmsignal bzw. der Effektivwert zumindest eines frequenzbereichsabhängigen Differenzstromes oder des gesamten Differenzstromes kommuniziert werden kann. Dieses ist vorteilhaft, weil eine Differenzstromüberwachung ermöglicht wird, mit welcher an verschiedenen Orten einer elektrischen Anlage Differenzströme ermittelt werden können, wobei die Alarmsignale bzw. frequenzbereichsabhängige Werte von Differenzströmen oder des gesamten Differenzstromes übertragen werden können, so dass zum Beispiel eine zentrale Überwachung einer elektrischen Anlage ermöglicht wird. Die Kommunikationsschnittstelle 18 kann zur drahtgebundenen oder drahtlosen Datenübertragung ausgebildet sein.

In kompakter Weise ist ein Summenstromwandler 11, eine Auswerteeinheit 13, eine Anzeigeeinheit 15, eine zumindest erste Ausgangseinheit 16 sowie eine Kommunikationsschnittstelle 18 gemeinsam in einem Gehäuse angeordnet sind, so dass beispielsweise ein kompaktes Gerät als Differenzstrom-Monitor 10 ausgebildet ist und autark betrieben werden kann.

Eine mit der ersten Ausgangseinheit 16 verschaltete Schalteinrichtung 3, wie zum Beispiel ein Schaltschütz zur Abschaltung der zumindest zwei Stromleitungen 2, ist vorgesehen, so dass bei Überschreitung oder Unterschreitung eines oder mehrerer Schwellwerte eine- Abschaltung der Stromleitungen 2 initiiert wird. Dieses hat den Vorteil, dass nicht nur eine Meldung, sondern durch die Abschaltung eine Schutzpegelerhöhung für die elektrische Anlage realisiert wird.

Die Kommunikationsschnittstelle 18 als Ethernet-Schnittstelle mit der Funktion POE (Power Over Ethernet) ausgeführt. In vorteilhafter Weise werden beispielsweise ein Summenstromwandler 11, eine Auswerteeinheit 13, eine Anzeigeeinheit 15, eine erste Ausgangseinheit 16, eine zweite Ausgangseinheit 17 sowie eine Kommunikationsschnittstelle 18 mit elektrischer Energie versorgt, so dass keine weitere Energiequelle beispielsweise in Form eines Netzteils erforderlich ist.

Mittels einer Energieschnittstelle 19 kann eine externe Energiequelle zum Beispiel ein externes Netzteil zur Energieversorgung verwendet werden, wenn die Funktion POE nicht verfügbar ist. Die Energieschnittstelle 19 ist zumindest mit der Auswerteeinheit 13 verbunden. Somit kann eine Vorrichtung zur Differenzstromüberwachung 1 in vorteilhafter Weise auch autark ohne eine Verbindung mittels Kommunikationsschnittstelle 18 betrieben werden.

Die Kommunikationsschnittstelle 18 ist mit einer Zentraleinheit 5 verbunden ist. Über die Kommunikationsschnittstelle 18 können Daten wie beispielsweise der Effektivwert des Gesamtdifferenzstromes oder die Effektivwerte von Frequenzbereichen des Differenzstromes an die Zentraleinheit 5 übermittelt und in der Zentraleinheit 5 ausgewertet werden. Dabei ist die Kommunikationsschnittstelle 18 mittels eines Ethernet-Bus 8 mit einer Zentraleinheit 5 verbunden. Die Zentraleinheit 5 ist als Computer mit Software ausgeführt. Mit Hilfe einer bidirektionalen Verbindung zur Datenübertragung können in vorteilhafter Weise sowohl Daten empfangen werden, als auch Daten beispielsweise zur Änderung von frequenzbereichsabhängigen Schwellwerten oder zur Änderung des Bemessungsdifferenzstromes oder auch zur Änderung von Grenzen von Frequenzbereichen bzw. einzelnen Frequenzen gesendet werden. Die Zentraleinheit 5 kann zudem in vorteilhafter Weise sowohl empfangene Daten auswerten und in optischer oder akustischer Art zur Anzeige bringen, aber auch Daten archivieren. Dieses ist vorteilhaft, weil eine Festlegung der Schwellwerte unter Berücksichtigung der gegebenen Anwendung oder besonderer Gegebenheiten einer elektrischen Anlage durch den Benutzer ermöglicht wird. Dadurch bestehen in vorteilhafter Weise eine hohe Funktionalität und Flexibilität.

Die Zentraleinheit 5 ist als Computer mit Software ausgeführt. Mit Hilfe einer bidirektionalen Verbindung zur Datenübertragung können in vorteilhafter Weise sowohl Daten empfangen werden, als auch Daten beispielsweise zur Änderung von frequenzbereichsabhängigen Schwellwerten oder zur Änderung des Bemessungsdifferenzstromes oder auch zur Änderung von Grenzen von Frequenzbereichen bzw. einzelnen Frequenzen gesendet werden. Die Zentraleinheit 5 kann zudem in vorteilhafter Weise sowohl empfangene Daten auswerten und in optischer oder akustischer Art zur Anzeige bringen, aber auch Daten archivieren. Dieses ist vorteilhaft, weil eine Festlegung der Schwellwerte unter Berücksichtigung der gegebenen Anwendung oder besonderer Gegebenheiten einer elektrischen Anlage durch den Benutzer ermöglicht wird. Dadurch bestehen in vorteilhafter Weise eine hohe Funktionalität und Flexibilität.

Die Zentraleinheit 5 ist so ausgestaltet, dass Daten von mehreren Differenzstrom-Monitoren 10 übertragbar bzw. auswertbar sind und zur Anzeige gebracht werden können. Dieses ist besonders vorteilhaft, weil somit erfasste Differenzströme an verschiedenen Orten der elektrischen Anlage zentral ausgewertet werden können und eine vollumfängliche Überwachung der gesamten elektrischen Anlage ermöglicht wird.

Dabei ist die Zentraleinheit 5 mit zumindest einer Schalteinrichtung 4 zur Abschaltung der zumindest zwei Stromleitungen 2 der elektrischen Anlage verbunden. Die Verbindung kann beispielsweise mit Hilfe eines Ethernet-Bus 8 erfolgen. Dieses hat den Vorteil, dass durch eine Abschaltung für die elektrische Anlage eine Schutzpegelerhöhung realisiert wird.

Weiterhing ist zur Herstellung von Datenverbindungen zwischen zumindest einem Differenzstrom-Monitor 10 und einer Zentraleinheit 5 ein Gateway 6 mit dem Differenzstrom-Monitor 10 und der Zentraleinheit 5 verbunden. Das Gateway 6 kann zudem in vorteilhafter Weise zu einer lokalen Aufzeichnung und Speicherung von Software vorgesehen werden.

Das Gateway 6 ist zu einer Cloud-basierten Aufzeichnung und Speicherung von Software vorgesehen. Dieses ist vorteilhaft, weil auf die Software in der Cloud 7 von verschiedenen Orten und/oder verschiedenen Benutzern zugegriffen werden kann.

Bevorzugt sind einzelne oder ausgewählte Datenverbindungen zur verschlüsselten Übertragung von Daten ausgebildet. Die Kommunikationsschnittstelle 18, die Auswerteeinheit 13, die Zentraleinheit 5, das Gateway 6 und/oder die Software können zur Verschlüsselung und/oder Entschlüsselung von Daten ausgebildet sein. Insbesondere kann ein von der Kommunikationsschnittstelle 18 eines Differenzstrommonitors 10 verschlüsselter Datenstrom von der Zentraleinheit 5, dem Gateway 6 und/oder der Software entschlüsselt werden. Ein von dem Gateway 6 verschlüsselter Datenstrom kann von der Zentraleinheit 5, der Kommunikationsschnittstelle 18 eines Differenzstrommonitors 10, einem weiteren Gateway 6 und/oder der Software entschlüsselt werden. Ebenso kann ein von der Zentraleinheit 5 oder der Software verschlüsselter Datenstrom von einem Gateway 6, oder einer Kommunikationsschnittstelle 18 eines Differenzstromwandlers 10 entschlüsselt werden.

Besonders ist, dass die Vorrichtung zur Differenzstromüberwachung 1 mittels Methoden des maschinellen Lernens als Kernfunktion der künstlichen Intelligenz durch Erlerntes aus der Vergangenheit Anomalien im Differenzstrom in einer elektrischen Anlage erkennen und diese dem Benutzer der elektrischen Anlage durch eine Meldung und/oder eine Anzeige insbesondere mittels einer Anzeigeeinheit 15 oder Zentraleinheit 5 übermittelt. Bevorzugt ist vorgesehen, dass sich die Software zum maschinellen Lernen in einer Cloud 7 befindet. Alternativ kann sich diese Software auch in einem zur Herstellung von Datenverbindungen vorgesehenen Gateway 6 oder an einem anderen Ort mit einer Möglichkeit zur Speicherung von Software insbesondere in einem Softwarespeicher einer mit einem Microcomputer mit Softwarespeicher 14 ausgebildeten Auswerteeinheit 13 befinden. In vorteilhafter Weise wird somit eine weitere Steigerung der Verfügbarkeit einer elektrischen Anlage erreicht.

Die Vorrichtung zur Differenzstromüberwachung 1 ermittelt dabei mittels Methoden des maschinellen Lernens den Entstehungsort eines Differenzstromes und somit also auch eine Fehlerquelle in einer elektrischen Anlage. In vorteilhafter Weise kann der Benutzer einer elektrischen Anlage somit einen Fehler in einfacher und schneller Weise beheben.

Weiterhin kann die Vorrichtung zur Differenzstromüberwachung 1 mittels Methoden des maschinellen Lernens Vorhersagen von Änderungen des Differenzstromes sowohl zum Ort der Entstehung (Ort der Fehlerquelle) als auch zum Zeitpunkt des Entstehens der Änderungen treffen. In vorteilhafter Weise können dem Nutzer der elektrischen Anlage, auch unter dem Aspekt der vorbeugenden Instandhaltung, frühzeitig unzulässige Änderungen des Differenzstromes mitgeteilt werden, um unzulässige Zustände oder Ausfälle in der elektrischen Anlage zu vermeiden.

**Patentansprüche**

1. Vorrichtung zur Differenzstromüberwachung (1) in elektrischen Anlagen mit wenigsten zwei Stromleitungen (2), aufweisend einen zumindest eine Sekundärwicklung (12) umfassenden Summenstromwandler (11) durch den die wenigstens zwei Stromleitungen (2) geführt sind und die Primärwicklungen des Summenstromwandlers (11) ausbilden, eine mit der Sekundärwicklung (12) verbundene Auswerteeinheit (13), die dazu ausgebildet ist, das Summenstromsignal der Sekundärwicklung (12) frequenzselektiv zu filtern und für zumindest zwei Frequenzbereiche den jeweiligen Effektivwert des Summenstromsignals in Jedem dieser Frequenzbereiche zu ermitteln, und dass die Auswerteeinheit (13) weiter dazu ausgebildet ist den für jeden Frequenzbereich ermittelten Effektivwert mit zumindest zwei frequenzbereichsabhängigen Schwellwerten zu vergleichen und bei einer Überschreitung eines ersten Schwellwertes ein frequenzbereichsabhängiges erstes Alarmsignal auszugeben und bei einer Unterschreitung eines zweiten Schwellwertes ein frequenzbereichsabhängiges zweites Alarmsignal auszugeben.

2. Vorrichtung nach Anspruch 1, **dadurch gekennzeichnet, dass** die Auswerteeinheit (13) zumindest einen Microcomputer mit Softwarespeicher (14) aufweist.

3. Vorrichtung nach Anspruch 1 oder 2, **dadurch gekennzeichnet, dass** der Summenstromwandler (11) dazu ausgebildet ist, Wechseldifferenzströme und Gleichdifferenzströme separat zu erfassen und diese in der Auswerteeinheit (13) separat auszuwerten.

4. Vorrichtung nach einem der Ansprüche 1 bis 3, **dadurch gekennzeichnet, dass** die Auswerteeinheit (13) für zumindest einen Frequenzbereich den ermittelten Effektivwert mit einem dritten frequenzbereichsabhängigen Schwellwert vergleicht und bei Überschreitung eines dritten Schwellwertes ein frequenzbereichsabhängiges drittes Alarmsignal ausgibt, wobei der Wert eines dritten frequenzbereichsabhängigen Schwellwertes niedriger ist als der Wert eines ersten frequenzbereichsabhängigen Schwellwertes.

5. Vorrichtung nach einem der Ansprüche 1 bis 4, **dadurch gekennzeichnet, dass** zumindest eine Anzeigeeinheit (15) mit der Auswerteeinheit (13) verbunden ist, wobei die Anzeigeeinheit (15) dazu ausgebildet ist, zumindest ein frequenzbereichsabhängiges Alarmsignal oder die Höhe des frequenzbereichsabhängigen Differenzstromes anzuzeigen, wobei die Anzeigeeinheit (15) vorzugsweise als LED und insbesondere als mehrfarbige LED ausgeführt ist, wobei insbesondere unterschiedliche Farben der LED verschiedenen Zuständen des erfassten Differenzstromes zugeordnet sind.

6. Vorrichtung nach einem der Ansprüche 1 bis 5, **dadurch gekennzeichnet, dass** eine erste Ausgangseinheit (16) mit der Auswerteeinheit (13) verbunden ist, wobei die Ausgangseinheit (16) mindestens einen ersten Ausgang aufweist, welcher insbesondere als Relais oder Halbleiter-Schalter ausgeführt ist, und wobei die Ausgangseinheit (16) derart ausgestaltet ist, dass zumindest ein frequenzbereichsabhängiges erstes Alarmsignal eine Schaltung des ersten Ausganges bewirkt.

7. Vorrichtung nach einem der Ansprüche 1 bis 6, **dadurch gekennzeichnet, dass** eine zweite Ausgangseinheit (17) mit der Auswerteeinheit (13) verbunden ist, wobei die zweite Ausgangseinheit (17) mindestens einen zweiten Ausgang aufweist, welcher insbesondere als Relais oder Halbleiter-Schalter ausgeführt ist, und wobei die zweite Ausgangseinheit (17) derart ausgestaltet ist, dass zumindest ein frequenzbereichsabhängiges zweites oder drittes Alarmsignal eine Schaltung des zweiten Ausganges bewirkt.

8. Vorrichtung nach einem der Ansprüche 1 bis 7, **dadurch gekennzeichnet, dass** zumindest eine Kommunikationsschnittstelle (18) mit der Auswerteeinheit (13) verbunden ist, wobei mittels der Kommunikationsschnittstelle (18) insbesondere ein frequenzbereichsabhängiges Alarmsignal bzw. der Effektivwert zumindest eines frequenzbereichsabhängigen Differenzstromes oder des gesamten Differenzstromes kommuniziert werden kann, wobei die Kommunikationsschnittstelle (18) vorzugsweise zur drahtgebundenen oder drahtlosen Datenübertragung, insbesondere als Ethernet-Schnittstelle mit der Funktion POE (Power Over Ethernet) ausgebildet ist.

9. Vorrichtung nach einem der Ansprüche 1 bis 8, **dadurch gekennzeichnet, dass** der Summenstromwandler (11), die Auswerteeinheit (13), die Anzeigeeinheit (15), die erste Ausgangseinheit (16) sowie die Kommunikationsschnittstelle (18) gemeinsam in einem Gehäuse angeordnet einen Differenzstrom-Monitor (10) ausbilden, wobei optional eine Energieschnittstelle (19) zur Energieversorgung zumindest mit der Auswerteeinheit (13) verbunden ist.

10. Vorrichtung nach einem der Ansprüche 6 bis 9, **dadurch gekennzeichnet, dass** eine mit der ersten Ausgangseinheit (16) oder mit der zweiten Ausgangseinheit (17) verbundene Schalteinrichtung (3) eine Abschaltung der zumindest zwei Stromleitungen (2) bewirkt.

11. Vorrichtung nach einem der Ansprüche 1 bis 10, **dadurch gekennzeichnet, dass** zwischen der Kommunikationsschnittstelle (18) und einer Zentraleinheit (5) eine bidirektionale Verbindung zur Datenübertragung besteht, insbesondere mittels eines Ethernet-Bus (8).

12. Vorrichtung nach Anspruch 11, **dadurch gekennzeichnet, dass** die Zentraleinheit (5) als Computer mit Software ausgebildet ist und/oder die Zentraleinheit (5) so ausgestaltet ist, dass Daten von mehreren Differenzstrom-Monitoren (10) übertragbar bzw. auswertbar sind.

13. Vorrichtung nach einem der Ansprüche 12 bis 12, **dadurch gekennzeichnet, dass** die Zentraleinheit (5) zumindest mit einer Schalteinrichtung (4) zur Abschaltung der zumindest zwei Stromleitungen (2) der elektrischen Anlage, insbesondere mittels eines Ethernet-Bus (8), verbunden ist.

14. Vorrichtung nach einem der Ansprüche 1 bis 13, **dadurch gekennzeichnet, dass** zumindest der Differenzstrom-Monitor (10) und die Zentraleinheit (5) mit einem Gateway (6) zur Übertragung von Daten verbunden sind, insbesondere wobei das Gateway (6) zu einer Cloud-basierten Aufzeichnung und Speicherung von Software vorgesehen ist, wobei auf die Software in der Cloud (7) von verschiedenen Orten und/oder verschiedenen Benutzern aus zugegriffen werden kann.

15. Verfahren zur Differenzstromüberwachung in elektrischen Anlagen mittels einer Vorrichtung zur Differenzstromüberwachung (1) nach einem der vorhergehenden Ansprüche 1 bis 15, bei dem ein Summenstromsignal frequenzselektiv gefiltert wird und für zumindest zwei Frequenzbereiche der jeweilige Effektivwert des Summenstromsignals in jedem dieser Frequenzbereiche ermittelt wird, und bei dem für jeden Frequenzbereich der ermittelte Effektivwert mit zumindest zwei frequenzbereichsabhängigen Schwellwerten verglichen wird und dass bei einer Überschreitung eines ersten Schwellwertes ein frequenzbereichsabhängiges erstes Alarmsignal ausgegeben wird und dass bei einer Unterschreitung eines zweiten Schwellwertes ein frequenzbereichsabhängiges zweites Alarmsignal ausgegeben wird.

Fig. 1

Fig. 2

Europäisches Patentamt
European Patent Office
Office européen des brevets

# EUROPÄISCHER RECHERCHENBERICHT

Nummer der Anmeldung

EP 24 21 4676

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| Y | DE 10 2018 208077 A1 (SIEMENS AG [DE]) 28. November 2019 (2019-11-28) * das ganze Dokument * ----- | 1-15 | INV. H02H3/33 H02H5/10 |
| Y | EP 2 660 940 A1 (DANFOSS DRIVES AS [DK]) 6. November 2013 (2013-11-06) * Absätze [0010] - [0012], [0019], [0022] - [0035]; Abbildungen 1,5 * ----- | 1-15 | |
| Y | EP 0 990 292 B1 (WALTHER BENDER GMBH & CO KG DI [DE]) 2. April 2003 (2003-04-02) * Absätze [0030] - [0035], [0040] - [0043], [0051]; Abbildungen 1,5 * ----- | 3 | |
| Y | DE 10 2005 028881 A1 (SIEMENS AG [DE]) 4. Januar 2007 (2007-01-04) * Absätze [0006], [0039] - [0042]; Abbildungen 1,2 * ----- | 4 | |

RECHERCHIERTE SACHGEBIETE (IPC)

G01R
H02H

Der vorliegende Recherchenbericht wurde für alle Patentansprüche erstellt

| Recherchenort | Abschlußdatum der Recherche | Prüfer |
|---|---|---|
| München | 14. April 2025 | Palukova, Mila |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument
..................................................................
& : Mitglied der gleichen Patentfamilie, übereinstimmendes Dokument

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

EP 24 21 4676

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

14-04-2025

| Im Recherchenbericht angeführtes Patentdokument | Datum der Veröffentlichung | Mitglied(er) der Patentfamilie | | Datum der Veröffentlichung |
|---|---|---|---|---|
| DE 102018208077 A1 | 28-11-2019 | KEINE | | |
| EP 2660940 A1 | 06-11-2013 | KEINE | | |
| EP 0990292 B1 | 02-04-2003 | AT | E236470 T1 | 15-04-2003 |
| | | AU | 753466 B2 | 17-10-2002 |
| | | CN | 1267401 A | 20-09-2000 |
| | | DE | 19826410 A1 | 07-01-1999 |
| | | EP | 0990292 A1 | 05-04-2000 |
| | | ES | 2196582 T3 | 16-12-2003 |
| | | JP | 3763852 B2 | 05-04-2006 |
| | | JP | 2002505068 A | 12-02-2002 |
| | | US | 6392422 B1 | 21-05-2002 |
| | | WO | 9858432 A1 | 23-12-1998 |
| DE 102005028881 A1 | 04-01-2007 | AT | E522016 T1 | 15-09-2011 |
| | | CN | 101208845 A | 25-06-2008 |
| | | DE | 102005028881 A1 | 04-01-2007 |
| | | EP | 1894283 A1 | 05-03-2008 |
| | | WO | 2006136520 A1 | 28-12-2006 |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 10237342
- DE 102018208077